# EUROPEAN PATENT APPLICATION

(11) **EP 2 242 347 A1**
(43) Date of publication of application: **20.10.2010**
(21) Application number: 09711414.4
(22) Date of filing: 05.02.2009
(51) Int. Cl.: H05K 7/20

(54) **HEAT EXCHANGING DEVICE, AND DEVICE ADAPTED FOR HOUSING HEAT GENERATING ELEMENT AND USING THE HEAT EXCHANGING DEVICE**

(30) Priority: 12.02.2008 JP 2008030262; 12.02.2008 JP 2008030263; 31.03.2008 JP 2008091135
(71) Applicant: Panasonic Corporation, Kadoma-shi Osaka 571-8501 (JP)
(72) Inventor: TSUJI, Keisuke, c/o Panasonic Corporation IPROC, Osaka-shi, Osaka 540-6207 (JP); MATSUMOTO, Mutsuhiko, c/o Panasonic Corporation IPROC, Osaka-shi, Osaka 540-6207 (JP); FUNADA, Naoyuki, c/o Panasonic Corporation IPROC, Osaka-shi, Osaka 540-6207 (JP); NAKANO, Yuuji, c/o Panasonic Corporation IPROC, Osaka-shi, Osaka 540-6207 (JP); SHIBATA, Hiroshi, c/o Panasonic Corporation IPROC, Osaka-shi, Osaka 540-6207 (JP)
(74) Representative: Grünecker, Kinkeldey, Stockmair & Schwanhäusser Anwaltssozietät
(86) International application number: PCT/JP2009/000437
(87) International publication number: WO 2009/101773

(57) **Abstract**

A heat-exchanging device employed in a heat generator casing with a small installation area. The heat-exchanging device includes a heat exchanger, a first air blower, and a second air blower in a first case. The first case includes a first inlet, a first outlet, a second inlet, and a second outlet. The first outlet is disposed in a direction different from a direction facing the first inlet. The second outlet is disposed in a direction different from a direction facing the second inlet. A first path where a first fluid flows and a second path where a second fluid flows cross in the heat exchanger. Heat is exchanged between the first fluid and the second fluid. The first air blower establishes a first passage where the first fluid flows from the first inlet to the first outlet via the first path. The second air blower establishes a second passage where the second fluid flows from the second inlet to the second outlet via the second path.

## Description

### TECHNICAL FIELD

The present invention relates to heat-exchanging devices and heat generator casings using the heat-exchanging device.

### BACKGROUND ART

If a current of several tens of amperes travels through an electric device, such as a receiver and transmitter used in a base station of mobile phones, the electric device generates heat by electricity. Therefore, electric devices are sometimes called heat generators. To reliably use this kind of electric device (hereafter referred to as "heat generator"), cooling of the heat generator becomes extremely important. Conventionally, a base station (hereafter referred to as "heat generator casing") for mobile phones that contain the heat generator is configured as follows.

A conventional heat-exchanging device is described below with reference to drawings.

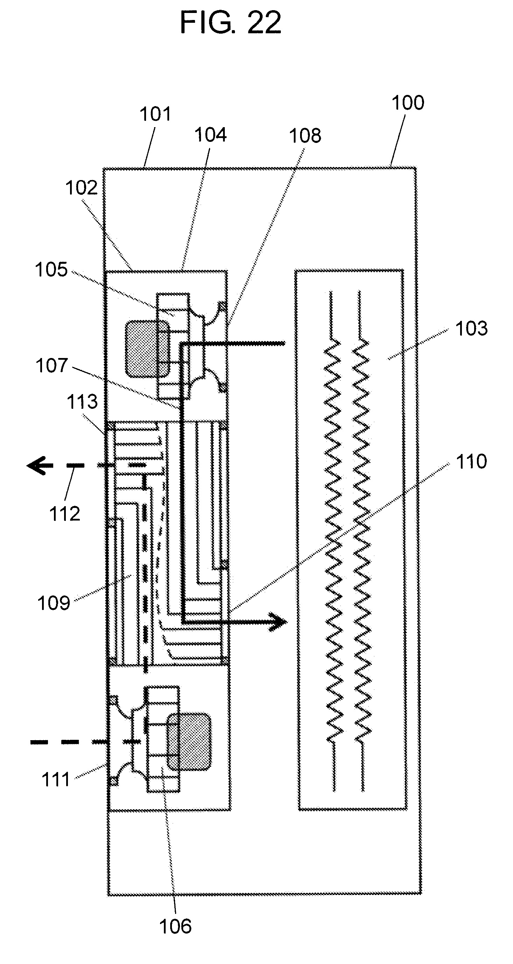

As shown in Fig. 22, a heat-exchanging device is housed in the heat generator casing. More specifically, heat generator casing 100 includes heat-exchanging device 102 and heat generator 103 inside housing 101. Internal air fan 105 and external air fan 106 are provided in case 104 of heat-exchanging device 102.

Heat generated by heat generator 103 is transferred to heat-exchanging device 102 via internal airflow 107, which is generated by internal air fan 105, in the housing. In other words, internal air near heat generator 103 is drawn into internal air inlet 108 by operating internal air fan 105. The heat of internal air drawn in is released to external air, which is described later, while the internal air passes through heat exchanger 109. The internal air after releasing heat is blown out to heat generator 103 through internal air outlet 110.

If external air fan 106 is operated, a flow of external air drawn 112 in from outside the housing is established. In other words, the external air passing through external air inlet 111 absorbs heat from aforementioned internal air while the external air passes through heat exchanger 109. External air absorbing heat is blown outside the housing through external air outlet 113.

As illustrated in the drawing, internal air fan 105 and external air 106 are disposed at positions facing each other relative to heat exchanger 109 installed on a wall of housing 101. This structure slims heat generator casing 100, and reduces the space needed for installing heat generator casing 100.

However, further downsizing of the area for installing heat generator casing 100 is demanded.
Patent Literature 1: Japanese Patent Unexamined Publication No. 2000-161875
Patent Literature 2: Japanese Patent Unexamined Publication No. 2001-99531

### SUMMERY OF THE INVENTION

A heat-exchanging device of the present invention includes a first air blower and a second air blower inside a first case.

The first case includes a first inlet, first outlet, second inlet, and second outlet. The first inlet draws in a first fluid. The first outlet is provided in a direction different from that facing the first inlet. The first outlet blows out the first fluid. The second inlet draws in a second fluid. The second outlet is provided in a direction different from that facing the second inlet. The second outlet blows out the second fluid. The first air blower makes the first fluid flow from the first inlet to the first outlet via a first path. This forms a first passage. The second air blower makes the second fluid flow from the second inlet to the second outlet via a second path. This forms a second passage. The first passage where the first fluid flows and the second passage where the second fluid flows exchange heat between the first fluid and the second fluid inside the heat exchanger.

If this heat-exchanging device is used in a heat generator casing, two flows are formed: The first fluid passing inside and outside of the heat generator casing, and the second fluid circulating in the heat generator casing.

### BRIEF DESCRIPTION OF DRAWINGS

Fig. 1 is a perspective view of a heat-exchanging device in accordance with a first exemplary embodiment of the present invention.
Fig. 2 is an exploded view of a heat exchanger in accordance with the first exemplary embodiment of the present invention.
Fig. 3 is a perspective view of the heat-exchanging device in accordance with the first exemplary embodiment of the present invention.
Fig. 4 is a perspective view of the heat-exchanging device in accordance with the first exemplary embodiment of the present invention.
Fig 5 is a perspective view of the heat-exchanging device in accordance with the first exemplary embodiment of the present invention.
Fig. 6 is a perspective view of a heat generator casing in accordance with a second exemplary embodiment of the present invention.
Fig. 7 is an internal layout of the heat generator casing in accordance with the second exemplary embodiment of the present invention.
Fig. 8 is an internal layout of the heat generator casing in accordance with the second exemplary embodiment of the present invention.
Fig. 9 is a perspective view of a heat generator casing in accordance with a third exemplary embodiment of the present invention.
Fig. 10 is an internal layout of the heat generator casing in accordance with the third exemplary embodiment of the present invention.
Fig. 11 is an internal layout of the heat generator casing in accordance with the third exemplary embodiment of the present invention.
Fig, 12 is an internal layout of the heat generator casing in accordance with the third exemplary embodiment of the present invention.
Fig. 13 is a perspective view of the heat generator casing in accordance with the third exemplary embodiment of the present invention.
Fig. 14 is a vertical sectional view of a key part of a heat generator casing in accordance with a fourth exemplary embodiment of the present invention.
Fig. 15 is a vertical sectional view of a key part of the heat generator casing in accordance with the fourth exemplary embodiment of the present invention.
Fig. 16 is a magnified view of a key part of the heat generator casing in accordance with the fourth exemplary embodiment of the present invention.
Fig. 17 is a magnified view of a key part of the heat generator casing in accordance with the fourth exemplary embodiment of the present invention.
Fig. 18A is a magnified view of a key part of the heat generator casing in accordance with the fourth exemplary embodiment of the present invention.
Fig. 18B is a magnified view of a key part of the heat generator casing in accordance with the fourth exemplary embodiment of the present invention.
Fig. 19 is a vertical sectional view of a key part of the heat generator casing in accordance with the fourth exemplary embodiment of the present invention.
Fig. 20 is a vertical sectional view of a key part of the heat generator casing in accordance with the fourth exemplary embodiment of the present invention.
Fig. 21 is a vertical sectional view of a key part of the heat generator casing in accordance with the fourth exemplary embodiment of the present invention.
Fig. 22 is a conceptual diagram of a conventional heat generator casing.

### REFERENCE MARKS IN THE DRAWINGS

- 1, 1a: Heat-exchanging device
- 2, 2a: Case (first case)
- 2b: Case (third case)
- 3,42: Heat exchanger
- 4, 38a: Fan (first air blower)
- 5, 44a: Fan (second air blower)
- 6, 39a: Inlet (first inlet)

- 7, 40a: Outlet (first outlet)
- 8, 48, 48a: Inlet (second inlet)
- 9, 46, 46a: Outlet (second outlet)
- 12, 12a: Path (first path)
- 12b: Path (second path)
- 15, 41a, 58a: Passage (first passage)
- 16, 45a, 59a: Passage (second passage)
- 18: Inlet (third inlet)
- 19: Outlet (third outlet)
- 20: Cover (first cover)
- 21: Cover (second cover)
- 30, 50: Heat generator casing
- 31, 51: Housing
- 32: Case (second case)
- 33: Heat-exchanging device
- 33a: Heat-exchanging device (first heat-exchanging device)
- 33b: Heat-exchanging device (second heat-exchanging device)
- 34, 34a: Side face (first side face)
- 34b: Side face (third wall)
- 35: Rear face (second wall)
- 36, 36a: Opening (first opening)
- 36b: Opening (third wall)
- 37: Opening (second opening)
- 38b: Fan (third air blower)
- 39b: Inlet (third inlet)

- 49b: Outlet (third outlet)
- 41b, 58b: Passage (third passage)
- 42a: Heat exchanger (first heat exchanger)
- 42b: Heat exchanger (second heat exchanger)
- 44: Fan
- 44b: Fan (fourth air blower)
- 45, 45d, 45e, 59: Passage
- 45b, 59b: Passage (fourth passage)
- 46b: Outlet (fourth outlet)
- 47, 60, 60a, 60b, 60c: Duct
- 48b: Inlet (fourth inlet)
- 52, 52a: Inner side face (fourth wall)
- 52b: Inner side face (sixth wall)
- 53: Inner rear face (fifth wall)
- 54, 54a: Opening (fourth opening)
- 54b: Opening (sixth opening)
- 55: Opening (fifth opening)
- 61: Inlet (duct inlet)
- 62, 62a, 62b, 62c: Outlet (duct outlet)
- 64: Door
- 70: Outlet (seventh outlet)
- 71: Guide (first guide)
- 72: Guide (second guide)
- 73: Case bottom (bottom face of the first case)
- 74: Case top (top face of the second case)

- 75: Protrusion (second attachment portion)
- 76: Guide fitting portion (first guide fitting portion)
- 77: Fitting portion
- 78: Packing
- 79: Auxiliary portion
- 80, 81: Slant
- 90: Attachment portion (first attachment portion)
- 91: Attachment portion (third attachment portion)
- 92: Attachment portion (second attachment portion)
- 103: Heat generator

### DETAILED DESCRIPTION OF PREFERRED EMBODIMENTS

Exemplary embodiments of the present invention are described below with reference to drawings. However, the exemplary embodiments herein are illustrative, and thus the present invention is not limited to these exemplary embodiments.

### (FIRST EXEMPLARY EMBODIMENT)

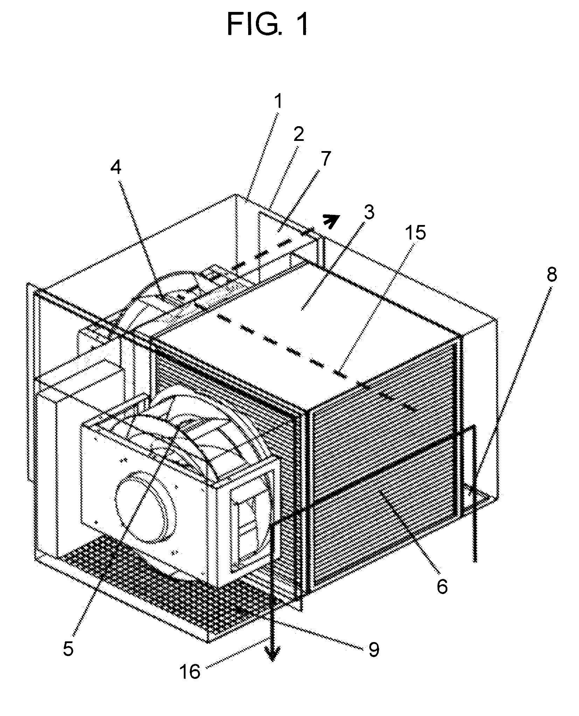

A heat-exchanging device in the first exemplary embodiment of the present invention is described below with reference to Figs. 1 to 5. Heat-exchanging device 1 includes heat exchanger 3, fan 4 that is the first air blower, and fan 5 that is the second air blower in case 2 that is the first case.

Case 2 includes inlet 6 that is the first inlet for drawing in external air as the first fluid, and outlet 7 that is the first outlet for blowing out external air that has passed through heat exchanger 3. Case 2 also includes inlet 8 that is the second inlet drawing in internal air as the second fluid, and outlet 9 that is the second outlet for blowing out internal air that has passed through heat exchanger 3. In the first exemplary embodiment, inlet 6 and outlet 7 for external air are provided on horizontally-adjacent side faces of case 2. Inlet 8 and outlet 9 for internal air are provided on a bottom face of case 2.

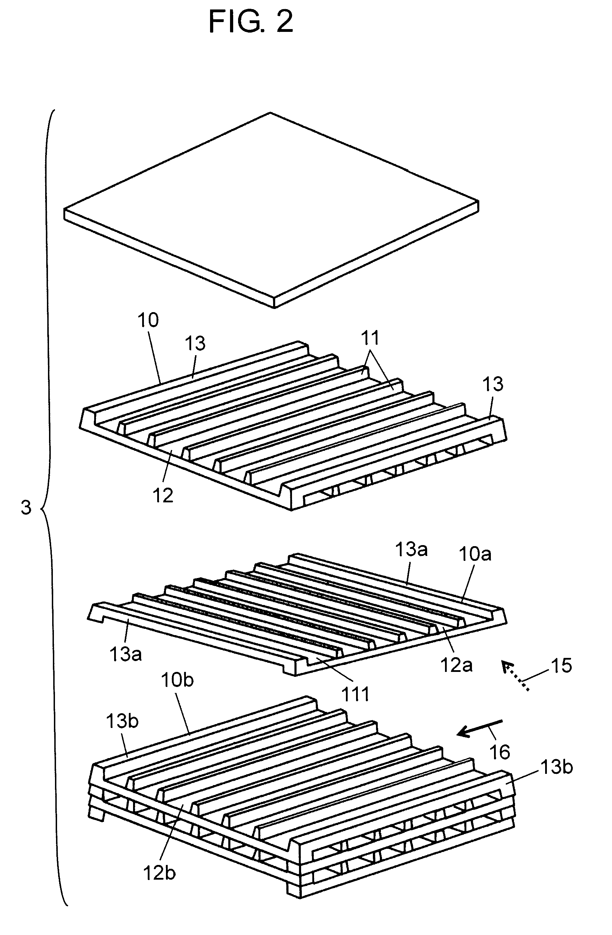

Heat exchanger 3 is described with reference to Fig. 2. Multiple ribs 11 are provided on the surface of heat exchanger plate 10. Path 12 is formed between these ribs 11. Blocking plate 13 is provided on the surface ends of heat exchanger plate 10 in the same direction as that of ribs 11. Multiple heat exchanger plates 10 as configured above are stacked in a 90-degree shifted manner alternately. As a result, the external air flows along path 12a that is the first path formed on heat exchanger plate 10a. The internal air flows along path 12b that is the second path formed on heat exchanger plate 10b. Blocking plates 13a provided on the ends of heat exchanger plate 10a prevent the internal air from flowing into path 12a on heat exchanger plate 10a. In the same way, blocking plates 13b provided on the ends of heat exchanger plate 10b prevent the external air from flowing into path 12b on heat exchanger plate 10b. With this structure, paths 12a and 12b are configured in directions crossing each other. External air and internal air flow along these paths 12a and 12b, respectively. As a result, the external air and the internal air exchange heat via heat exchanger plate 10a.

Heat exchanger plate 10 is made of a thermoplastic resin film, such as polystyrene, polypropylene, and polyethylene. Other than these materials, heat exchanger plate 10 may be typically made of a metal plate, such as aluminum, paper with heat conductivity and moisture permeability, a microporous resin film, or paper in which resin is mixed.

Heat exchanger plate 10 is typically formed by vacuum forming, pressured forming, extreme-pressure forming, or press forming.

A centrifugal air blower is used for fan 4 and fan 5. In the first exemplary embodiment, fan 4 is provided between heat exchanger 3 and outlet 7. Fan 5 is provided between heat exchanger 3 and outlet 9.

With this structure, fan 4 makes the external air passing through paths 12a in heat exchanger 3 flow in a direction perpendicular to path 12a. Accordingly, the external air drawn in from inlet 6 for external air passes along paths 12a, and flows to outlet 7. This flow of external air is passage15 that is the first passage.

In the same way, fan 5 makes the internal air passing through paths 12b in heat exchanger 3 flow in a direction perpendicular to paths 12b. Accordingly, the internal air drawn in from inlet 8 for internal air passes through path 12b, and flows to outlet 9. This flow of internal air is passage 16 that is the second passage.

More specifically, in heat exchanging device 1 in the first exemplary embodiment, fan 4 is provided between heat exchanger 3 and outlet 7, and fan 5 is provided between heat exchanger 3 and outlet 9. This structure makes directions of paths 12a and 12b in heat exchanger 3 the same directions as those of rotating axes of fans 4 and 5 respectively. By reducing the number of bends in heat exchanging device 1, a pressure loss due to bends in passages 15 and 16 can be suppressed. As a result, an installation area of heat exchanging device 1 can be reduced. In addition, since fans 4 and 5 act to draw out the external air and internal air passing through paths 12a and 12b, reduction in a flow rate of external air and internal air in passages 15 and 16 is suppressed. Furthermore, inlets 6 and 8 and outlets 7 and 9 are provided at predetermined positions. Accordingly, passage 15 is formed horizontally, and passage 16 is formed vertically. As a result, heat exchanging device 1 builds a three-dimensional passage in horizontal and vertical directions.

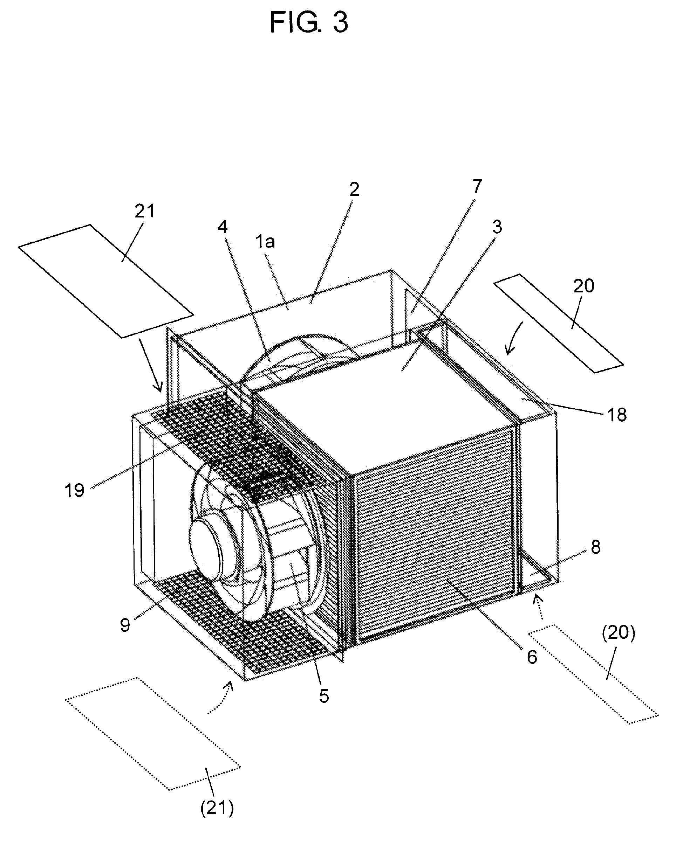

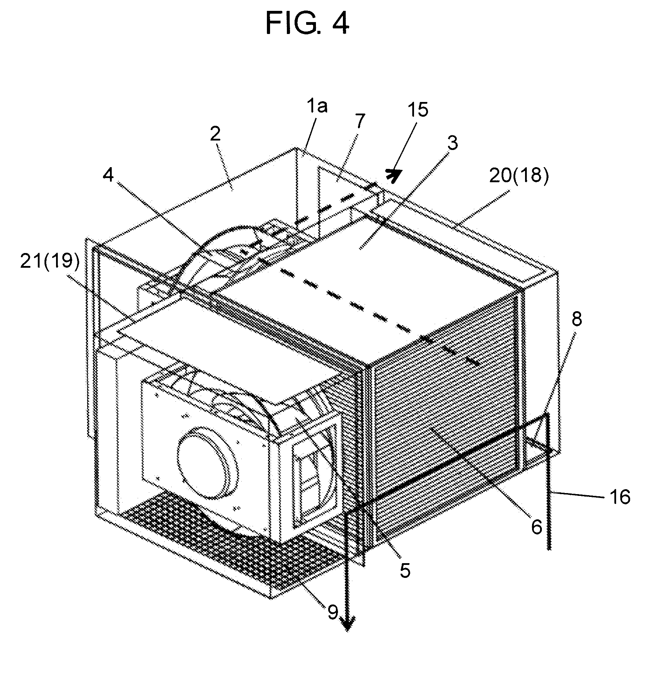

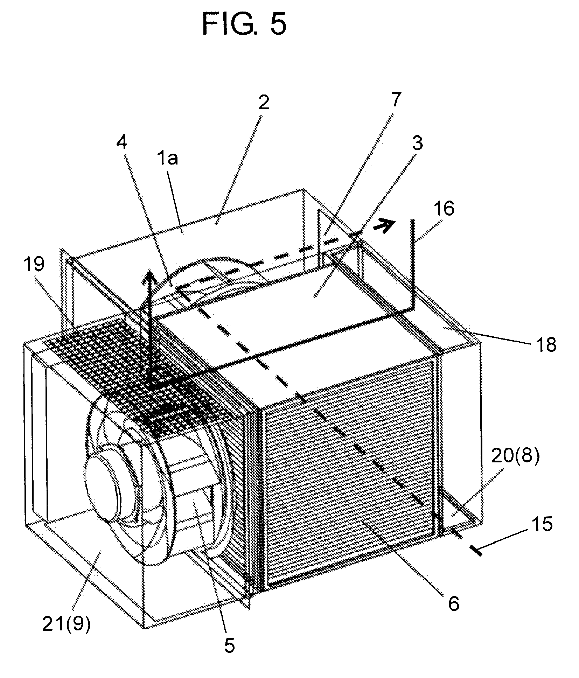

Next, as shown in Figs. 3 to 5, inlet 18 for internal air that is the third inlet, and outlet 19 that is the third outlet are provided on heat exchanging device 1a. Inlet 18 is disposed at a position facing inlet 8. Outlet 19 is disposed at a position facing outlet 9. Covers 20 and 21 that are the first cover and the second cover are provided on inlets 8 and 18 and outlets 9 and 19 respectively. As shown in Fig. 4, covers 20 and 21 are provided on unused inlet 18 and unused outlet 19 respectively so as to form predetermined passage 16. Alternatively, as shown in Fig. 5, to form predetermined passage 16, covers 20 and 21 are provided on unused inlet 8 and unused outlet 9 respectively. This structure establishes passage 16 of upward- or downward-stream relative to heat exchanging device 1a. In other words, directions of passages 15 and 16 can be changed with a single configuration of heat-exchanging device 1a.

Covers 20 and 21 are made of airtight elastic body formed of closed cell foam, such as ethylene propylene diene rubber foam (hereafter referred to as EPDM rubber foam), or the same material as steel plate configuring case 2. Air-tightness of inlets 8 and 18 or outlets 9 and 19 improve if they are covered with elastic body such as EPDM rubber foam.

With the above structure, heat-exchanging device 1a offers two installation directions by the single configuration. Heat-exchanging device 1a is disposed at symmetric positions in a heat generator casing. More specifically, heat-exchanging device 1a enables installation of symmetrical heat-exchanging devices at an upper part of the housing. The second fluid in the housing flows to the second passage, and exchanges the heat with the first fluid passing through the first passage. In this way, inside the housing is cooled down. As a result, an installation area of the heat generator casing can be reduced.

### (SECOND EXEMPLARY EMBODIMENT)

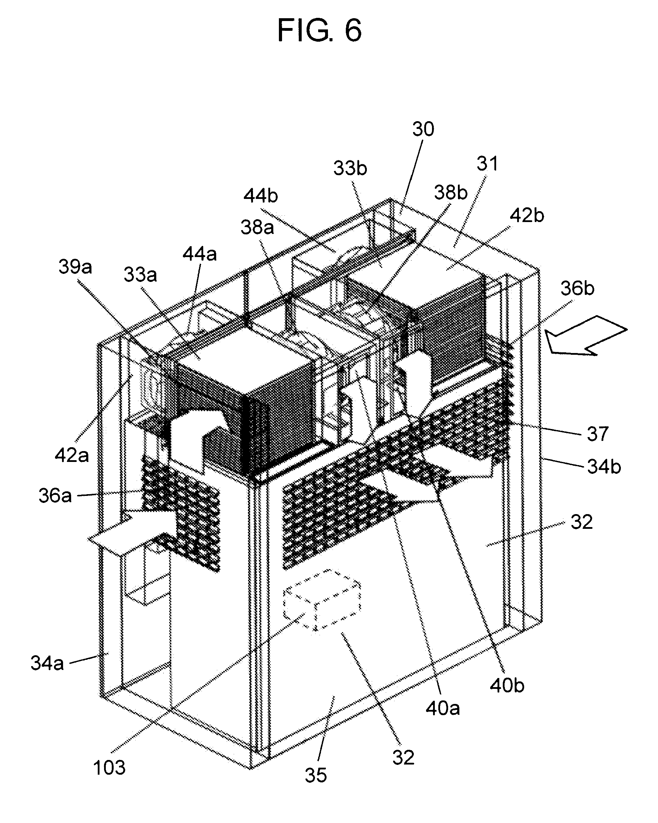

A heat generator casing using heat-exchanging device 1, which is described in the first exemplary embodiment, is described with reference to Figs. 6 to 8.

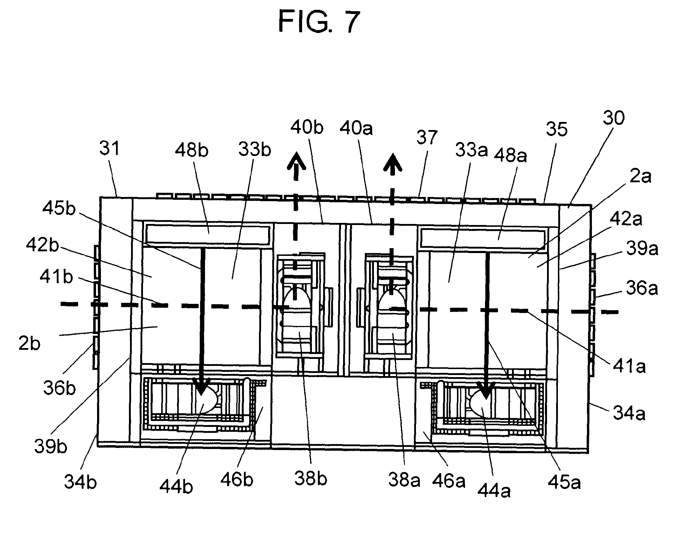

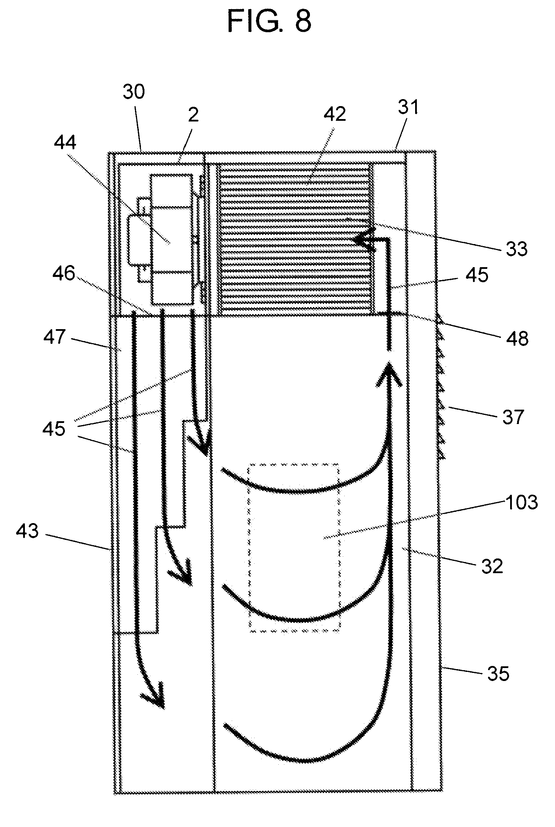

Fig. 6 is a perspective view of the heat generator casing seen from the rear oblique direction. Fig. 7 is an internal layout of the heat generator casing seen from the top. Fig. 8 is an internal layout of the heat generator casing seen from the side.

Heat generator casing 30 includes case 32 that is the second case inside housing 31. Heat-exchanging device 33a that is the first heat-exchanging device, and heat-exchanging device 33b that is the second heat-exchanging device are disposed on case 32. Heat-exchanging device 33a uses first case 2a. Heat-exchanging device 33b uses third case 2b.

Housing 31 includes side face 34a that is the first wall, side face 34b that is the third wall, and rear face 35 that is the second wall. Opening 36a that is the first opening and opening 36b that is the third opening for drawing in external air are provided on side faces 34a and 34b. Opening 37 that is the second opening for blowing out the external air passing through heat-exchanging devices 33a and 33b, which is described later, is provided on rear face 35.

Heat generator 103, such as a receiver or transmitter of mobile phone, is housed in case 32.

As shown in Figs. 6 and 7, fan 38a that is the first air blower and fan 38b that is the third air blower for blowing out external air are provided in heat-exchanging devices 33a and 33b on case 32 such that fan 38a and fan 38b face each other. Inlet 39a that is the first inlet of heat-exchanging device 33a and inlet 39b that is the third inlet of heat-exchanging device 33b are provided in a direction facing openings 36a and 36b, respectively. Outlet 40a that is the first outlet of heat-exchanging device 33a and outlet 40b that is the third outlet of heat-exchanging device 33b are provided in a direction facing opening 37. By disposing heat-exchanging devices 33a and 33b this way, passage 41a indicated by an arrow in the drawing is established as the first passage. As the third passage, passage 41b indicated by an arrow in the drawing is established. In other words, external air drawn in from openings 36 and 36b created in both side faces 34a and 34b of housing 31 flows to heat exchanger 42a that is the first heat exchanger and heat exchanger 42b that is the second heat exchanger. This external air passes through paths provided inside heat exchangers 42a and 42b in a rotating axis direction of fans 38a and 38b. Meanwhile, the external air exchanges heat with internal air, which is described later. The external air reaching fans 38a and 38b changes its direction for almost 90 degrees by fans 38a and 38b, and is blown out of housing 31 from opening 37 via outlets 40a and 40b. In this way, passages 41a and 41b are established as horizontal air passages.

On the other hand, as shown in Fig. 8, fan 44 (hereafter equivalent to fan 44a that is the second air blower and fan 44b that is the fourth air blower) is provided in housing 31 at the side of front face 43 in heat-exchanging device 33 (hereafter equivalent to heat-exchanging devices 33a and 33b). This fan 44 establishes passage 45 that is the second or fourth passage (hereafter equivalent to passage 45a that is the second passage and passage 45b that is the fourth passage) vertically circulating in housing 31or passage 45b that is the fourth passage.

The internal air exchanges heat with external air while the internal air passes through paths provided in heat exchanger 42 (hereafter equivalent to heat exchangers 42a and 42b). Fan 44 changes the flow direction of the internal air passing through heat exchanger 42 to a vertically downward direction. The internal air blown out from outlet 46 that is the second outlet (hereafter equivalent to second outlet 46a and fourth outlet 46b) via duct 47 to a lower part of housing 31 is led into case 32 that is the second case where heat generator 103 is housed. When the internal air passes inside case 32, the internal air takes away heat generated by heat generator 103. The internal air absorbing the heat is drawn into heat-exchanging device 33 from case 32 via inlet 48 that is the second inlet (hereafter equivalent to second inlet 48a and fourth inlet 48b).

As described above, heat generator casing 30 in the second exemplary embodiment has a structure described below. Heat-exchanging devices 33a and 33b establish passages 41a, 41b, 45a, and 45b in two directions, i.e. horizontal and vertical directions. These heat-exchanging devices 33a and 33b are disposed on case 32 housing the heat generator.

In heat generator casing 30 as configured above, heat generated by heat generator 103, such as a transmitter or receiver, increases the temperature of air inside case 32. This warmed air is drawn into heat-exchanging device 33 through inlet 48 by fan 44. On the other hand, fans 38a and 38b draw in external air, which is cold air outside housing 31, to heat-exchanging devices 33a and 33b through openings 36a and 36b and inlets 39a and 39b. Heat exchangers 42a and 42b installed in heat-exchanging devices 33a and 33b are configured by stacking up heat exchanger plates on which paths for passing air are provided. These heat exchangers 42a and 42b lead in air with temperature difference from two directions, so as to exchange heat between these streams of air. After exchanging the heat by drawing in the internal air and external air to these heat exchangers 42a and 42b, cooled internal air is blown out from outlet 46 into case 32 via duct 47. On the other hand, the external air warmed by heat exchange is blown out from outlets 40a and 40b to outside heat generator casing 30 via opening 37.

As described above, heat-exchanging device 33 in the first exemplary embodiment can reduce the installation area. Since the installation area is small, this heat-exchanging device 33 enables placement of two fans 39a and 38b facing each other on case 32. If centrifugal air blowers are used for fans 38a and 38b, external air is drawn in at a high flow rate from the entire paths of heat exchangers 42a and 42b configuring passages 41a and 41b to fans 38a and 38b. If the external air is drawn in at a high flow rate by fans 38a and 38b, the heat exchange efficiency of heat-exchanging devices 33a and 33b improves. In the same way, if two fans 44a and 44b are used, the internal air vertically circulating in housing 31 also flows fast. The fast flow of the internal air enables removal of more heat generated from the heat generator. Cooling performance of the heat generator thus improves.

As a result, heat generator casing 30 in the second exemplary embodiment can reduce its installation area.

Fig. 8 is an internal layout seen from side face 34a that is the first wall. Components related to first heat-exchanging device 33a illustrated in the drawing correspond to components of second heat-exchanging device 33b seen from side face 34b that is the third wall.

### (THIRD EXEMPLARY EMBODIMENT)

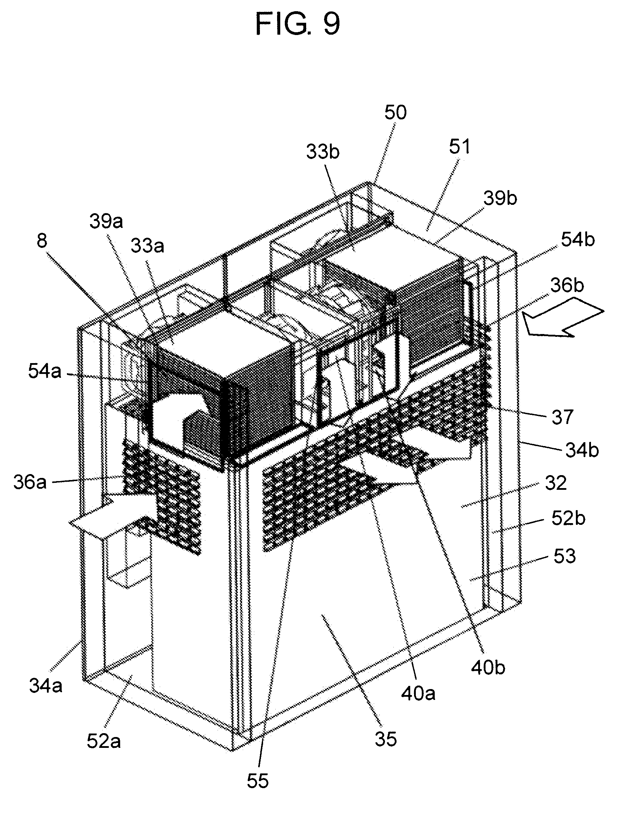

A heat generator casing in the third exemplary embodiment of the present invention is described with reference to Figs. 9 to 13. Components that have the same functions as those already described are given the same reference marks. Aforementioned description applies to components given the same reference marks.

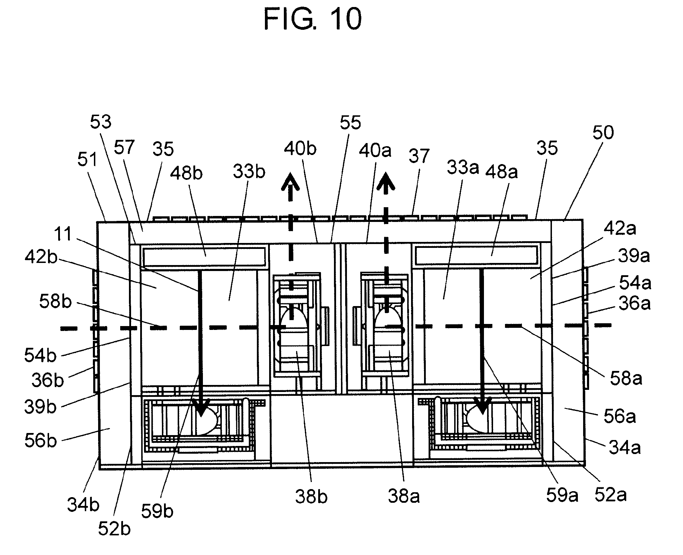

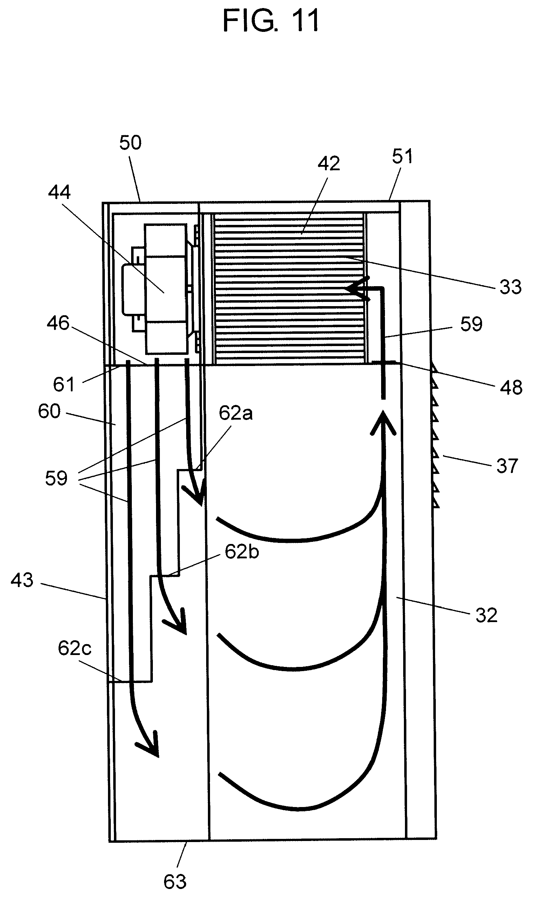

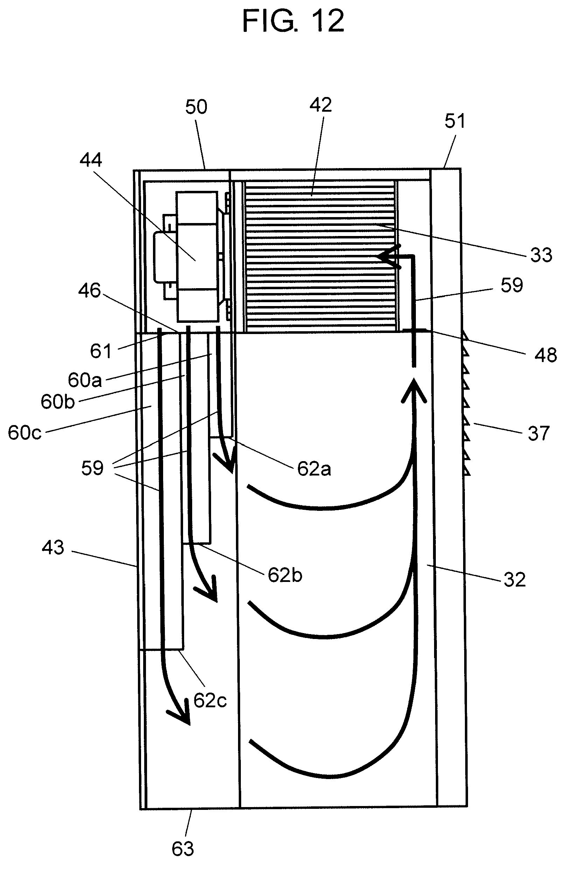

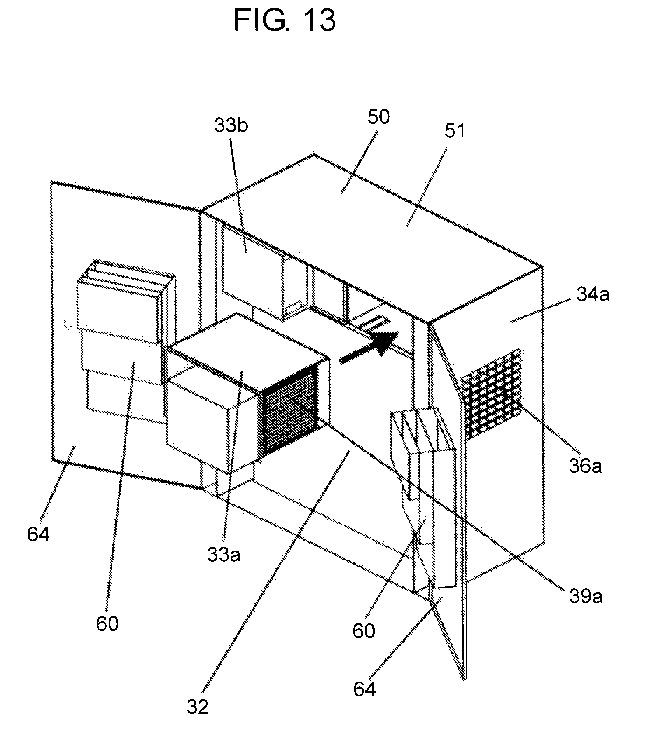

Fig. 9 is a perspective view of the heat generator casing seen from the rear oblique direction. Fig. 10 is an internal layout of the heat generator casing seen from the top. Figs. 11 and 12 are internal layouts of the heat generator casing seen from the side. Fig. 13 is a perspective view of the heat generator casing seen from the front oblique direction.

In heat generator casing 50, inner side face 52a that is the fourth side wall, inner side face 52b that is the six side wall, and inner rear face 53 that is the fifth wall are provided inside housing 51 configured with side face 34a that is the first wall, side face 34b that is the third wall, and rear face 35 that is the second wall. As shown in the drawings, opening 36a that is the first opening and opening 36b that is the third opening for drawing in external air are created near the center of side faces 34a and 34b. On inner side face 52a, opening 54a that is the fourth opening is provided at a position facing inlet 39a that is the first inlet of heat-exchanging device 33a. On inner side face 52b, opening 54b that is the sixth opening is created at a position facing inlet 39a that is the third inlet of heat-exchanging device 33b. Opening 36 and opening 54a, and opening 36b and opening 54b are created such that their open areas do not overlap.

Similarly, opening 37 that is the second opening for blowing out external air is provided near the center of rear face 35. On inner rear face 53, opening 55 that is the fifth opening is created at a position facing outlet 40a that is the first outlet of heat-exchanging device 33a and outlet 40b that is the third outlet of heat-exchanging device 33b. Opening 37 and opening 55 are created such that their open areas do not overlap.

As shown in Figs. 9 and 10, side face 34a and inner side face 52a form path 56a, and side face 34b and inner side face 52b form path 56b. Rear face 35 and inner rear face 53 form path 57.

In the above structure, passage 58a that is the first passage and passage 58b that is the third passage are established through the following routes by driving fans 38a and 38b. External air drawn in from openings 36a and 36b passes through paths 56a and 56b, and is led to openings 54a and 54b. The external air further passes through openings 54a and 54b and inlets 39a and 39b, and is drawn into heat-exchanging devices 33a and 33b. After the external air exchanges its heat with internal air in heat exchangers 42a and 42b in heat-exchanging devices 33a and 33b, fans 38a and 38b change a flow direction, and the external air is led to outlets 40a and 40b. The external air further passes through opening 55 and path 57, and is blown out through opening 37 to outside housing 51.

This heat generator casing 50 achieves the following effect. Passages 58a and 58b are bent only once in heat-exchanging devices 33a and 33b in the third exemplary embodiment. By reducing the number of bends in heat-exchanging devices 33a and 33b, pressure losses caused by bending of passages 58a and 58b can be suppressed. Since pressure losses are suppressed in heat-exchanging devices 33a and 33b, a predetermined cooling performance of heat generator casing 50 can be secured, even if a pressure loss occurs by providing openings 36a and 54a and openings 36b and 54b at different heights.

Accordingly, openings 54a, 54b, and 55 facing heat-exchanging devices 33a and 33b can be created at positions higher than those of openings 36a, 36b, and 37 that are directly open to outside housing 51. Therefore, even if heat generator casing 50 is installed outside, rainwater blowing in from openings 36a, 36b, and 37 is not drawn into heat-exchanging devices 33a and 33b. The cooling performance of heat generator housing 50 will thus last long.

Next is described passage 59 that is the fourth passage (hereafter equivalent to passage 59a that is the second passage and passage 59b that is the fourth passage) vertically formed inside housing 51 of heat generator casing 50.

As shown in Fig. 11, duct 60 is disposed between front face 43 of housing 51 and case 32. Inlet 61 that is a duct inlet is provided at a position facing outlet 46 that is the second outlet of heat-exchanging device 33. Outlets 62a, 62b, and 62c that are duct outlets are provided at a lower part in housing 51. Outlet 62c of duct 60 is provided near bottom face 63 of housing 51 so that passage 59 includes an internal air flow near bottom face 63 of the housing. As a result, heat inside housing 51 is efficiently released.

In addition, as shown in Fig. 12, multiple outlets 62a, 62b, and 62c of multiple ducts 60a, 60b, and 60c are provided at positions with different vertical heights. This structure enables to blow out the internal air in case 32 from different heights. As a result, the internal air spreads in housing 51, and heat generated in case 32 is led to inlet 48 along passage 59 without being retained. Fan 44 draws in the internal air, which is led to outlet 48, to heat exchanger 42. The heat generated in case 32 and carried to heat exchanger 42 through passage 59 is exchanged with passages 58a and 58b for external air by passing through heat exchanger 42. The heat transferred to passages 58a and 58b is released outside housing 51, as described above.

As shown in Figs. 11 and 12, duct 60 is configured in line with its purpose.

As shown in Fig. 13, duct 60 is installed on door 64 of housing 51. This structure enables quick checking at checking inside heat generator casing 50 because duct 60 moves together with door 64.

As a result, the side wall can be thinned, compared with a conventional heat generator casing in which the heat-exchanging device is installed on the side wall, such as a door. A heat generator casing with small installation area and a predetermined cooling performance can be achieved.

The second fluid in housing 51 circulates between inlet 48 and outlet 46 without causing short-circuit by installing heat-exchanging devices 33a and 33b at an upper part in housing 51. As a result, an installation area of heat generator casing 50 can be reduced. Still more, heat generator casing 50 achieves a predetermined freezing performance.

Furthermore, housing 51 has door 64 where duct 60 is provided. As a result, duct 60 is removed by opening door 64 at checking inside heat generator casing 50. Accordingly, inside the casing can be checked efficiently.

### (FOURTH EXEMPLARY EMBODIMENT)

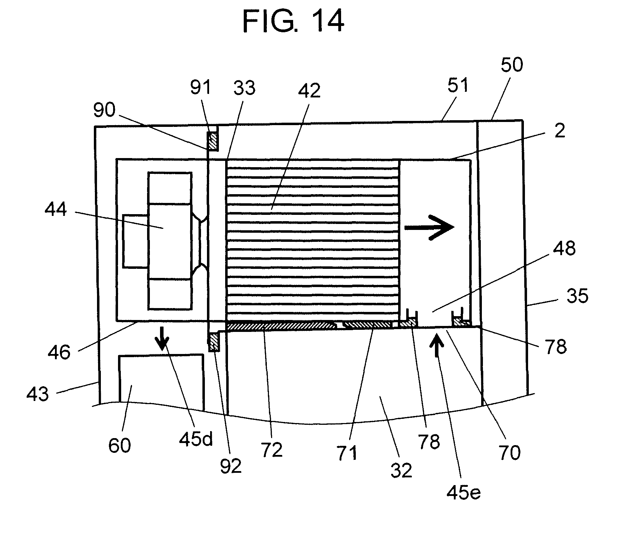

A heat generator casing in the fourth exemplary embodiment of the present invention is described with reference to Figs. 14 to 21. Components with functions similar to those already described are given the same reference marks. Aforementioned description is applied to components given the same reference marks.

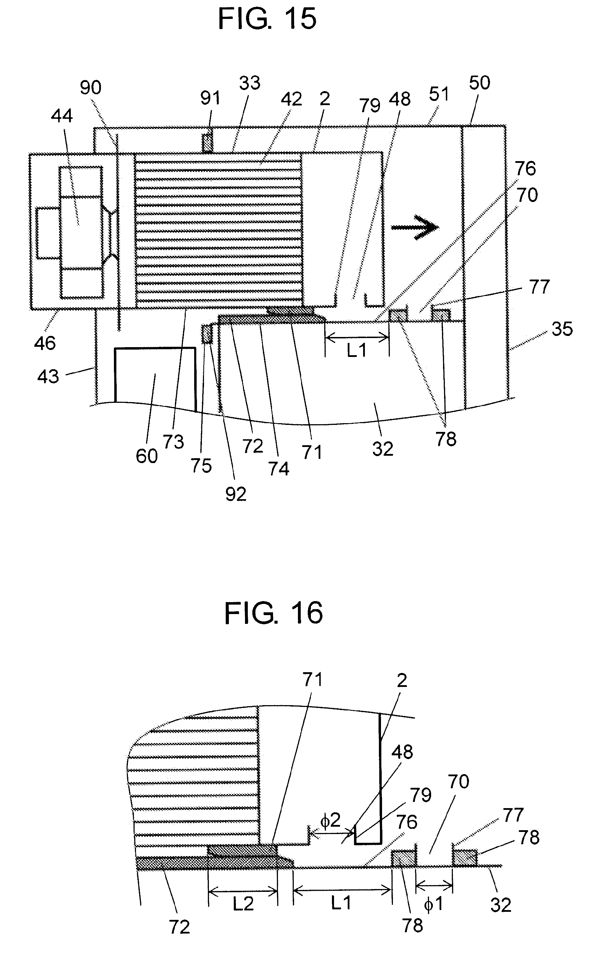

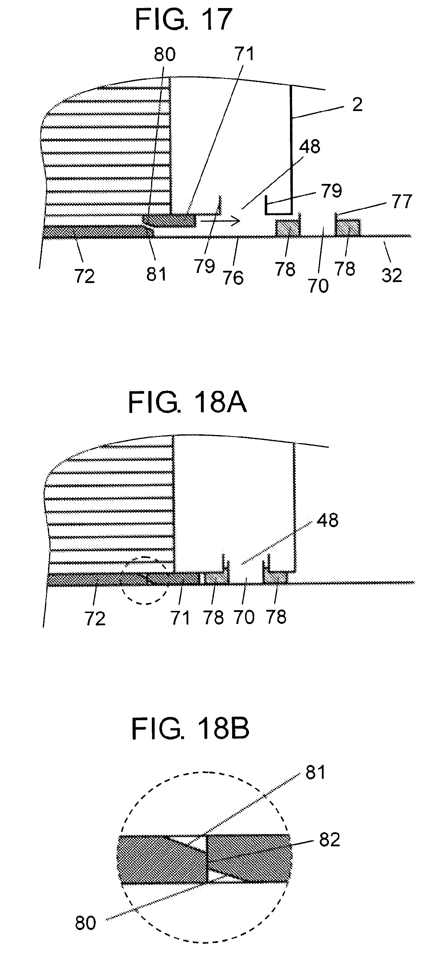

Figs. 14, 15, and 19 to 21 are vertical sectional views of a key part of the heat generator casing. Figs. 16 to 18A and 18B are magnified views of a key part of the heat generator casing.

As shown in Figs. 14 and 15, case 32 that is the second case where a heat generator is housed is provided inside heat generator casing 50. Heat-exchanging device 33 including case 2 that is the first case is disposed on this case 32.

As described in the first to third exemplary embodiments, outlet 46 that is the second outlet is provided to the side of front face 43 of housing 51, and inlet 48 that is the second inlet is provided to the side of rear face 35 of housing 51 in heat-exchanging device 33. Internal air blown out from outlet 46 is drawn into case 32 from a wall to the side of outlet 46 of case 2 via duct 60. The internal air drawn into case 32 rises along a wall to the side of inlet 48 of case 2, and is drawn into inlet 48 of heat-exchanging device 33 from outlet 70 that is the seventh outlet provided on case top 74, which is the top face of the second case. Accordingly, passages 45d and 45e that vertically circulate in housing 51 are formed by driving fan 44.

Guide 71 that is the first guide is provided on case bottom 73, which is the bottom face of the first case. Guide 71 slides on guide 72, which is described later, when case 2 is installed on case 32.

Outlet 70 is provided on case top 74 to circulate internal air from case 32 to inlet 48 of heat-exchanging device 33. As described in the first to third exemplary embodiments, passages 45d and 45e, which are circulating internal air streams, flow downward at the side of front face 43 of housing 51, and flows upward at the side of rear face 35 of housing 51. Accordingly, outlet 70 of case 32 is provided on case top 74 at the side of rear face 35 of housing 51. Guide 72 that is the second guide on which aforementioned guide 71 moves is provided on case top 74. Guide 71 and guide 72 are provided in a direction of helping the movement of case 2. In the fourth exemplary embodiment, this direction is a direction from front face 43 to rear face 35 of housing 51.

As shown in Fig. 15, protrusion 75 that is the second attachment portion is provided at a tip of guide 72. Protrusion 75 protrudes toward the direction of placing case 2 on case 32. With this structure, guide 71 can be easily positioned on guide 72 at placing case 2 on case 32.

Guide fitting portion 76 that is the first guide fitting portion is provided on case top 74 between guide 72 and outlet 70. As indicated in the drawing, length L1 of this guide fitting portion 76 is longer than length L2 of guide 71. This structure makes guide 71 and guide fitting portion 76 act as a positioner for attaching case 2 at a predetermined position on case 32.

Procedures for attaching case 2 on cast top 74 are further detailed next. As shown in Fig. 15, case 2 moves on case top 74 from the side of front face 43 to the side of rear face 35 of housing 51. As shown in Figs.16 to 18A and 18B, when inlet 48 provided on case bottom 73 reaches the position facing outlet 70 provided on guide 32, guide 71 is fitted into guide fitting portion 76. Fitting portion 77 protruding toward a heat-exchanging device is provided around outlet 70. Packing 78 is provided around this fitting portion 77. Auxiliary portion 79 protruding inward case 2 is provided at inlet 48 of case 2. Diameter Φ2 of inlet 48 of case 2 is larger than diameter Φ1 of fitting portion 77 provided at outlet 70 of case 32. Therefore, this fitting portion 77 is inserted into auxiliary portion 79. When fitting portion 77 is inserted into auxiliary portion 79, packing 8 fills around this insert portion. This increases air-tightness of the insert portion. If these fitting portion 77 and auxiliary portion 79 are provided, the next effect can be expected at installing heat generator casing 50 outside. Even if rainwater blows into housing 51, entry of rainwater into case 2 or case 32 can be suppressed.

As described above, heat-exchanging device 50 is attached by placing guide 71 provided on case bottom 73 on guide 72 provided on case top 74, and moving heat-exchanging device 50 on guide 72. With this structure, heavy heat-exchanging device 50 can be easily attached to case 32. Since the attachment position of case 2 is determined by fitting guide 71 into guide fitting portion 76, case 2 can be fixed without fine adjustment. In addition, since inlet 48 provided on case 2 and outlet 70 provided on case 32 are also fitted at the same time, a man-hour spent for attachment work can be reduced.

As shown in Figs. 16 to 18A and 18B, at least one of guide 71 and guide 72 is slanted. If a corner of guide 71 is slanted, slant 80 is created at a corner where guide 71 faces guide 72 and case top 74 when case 2 is placed on case 32. If a corner of guide 72 is slanted, slant 81 is created at a corner where guide 72 faces guide 71 and case bottom 73 when case 2 is placed on case 32. If slant 80 or 81 is created at a corner of at least guide 71 or 72, case 2 can be gradually lowered as guide 71 moves on guide 72, and is fitted into guide fitting portion 76. Accordingly, case 2 can be smoothly placed on case top 74.

Catch 82 is provided on guide 71 and guide 72 to engage each other. This structure enables accurate placement of case 2 on case top 74.

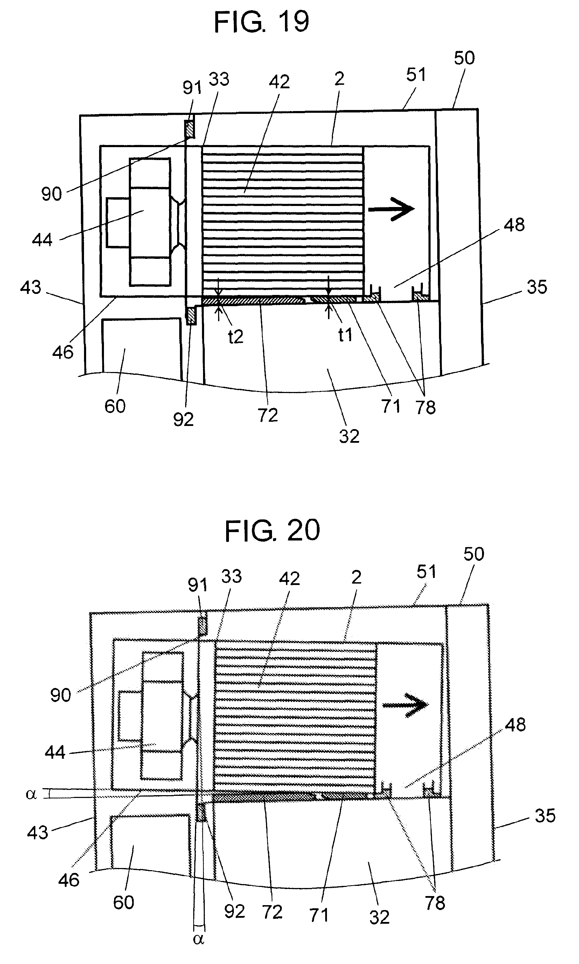

The heat generator casing is further described with reference to Figs. 19 to 21. Attachment portion 90 that is the first attachment portion is provided at a predetermined position around case 2. Attachment portion 91 that is the third attachment portion is provided on the inner top face of housing 51. Attachment portion 92 that is the second attachment portion is provided at a predetermined position of case 32. Case 2 is attached to a predetermined position on case 32 by using these attachment portions 90, 91, and 92. Attachment portion 91 and attachment portion 92 have the following structure so as to place tilted case 2 on case top 74.

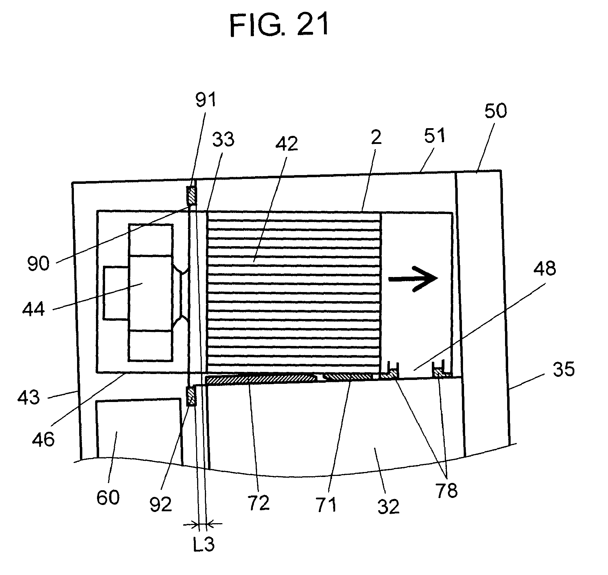

As shown in Figs. 20 and 21, attachment portion 91 and attachment portion 92 are vertically angled with predetermined angle α relative to housing 51. Alternatively, attachment positions of attachment portion 91 and attachment portion 92 are horizontally shifted for dimension L3.

As shown in Fig. 19, thickness t1 of guide 71 may be thinner than thickness t2 of guide 72.

With the above structures, case 2 is placed on case top 74 in a state that the side of inlet 48 is tilted downward. As a result, attachment pressure of outlet 70 and inlet 48 increases by its own weight of case 2. Air-tightness also improves.

This attachment method facilitates attachment on case 32 even if heat-exchanging device 33 is heavy.

As described above, the heat-exchanging device in the exemplary embodiment of the present invention is used in a heat generator casing. Two flows, i.e., the first fluid passing inside and outside the heat generator casing and the second flow circulating inside the heat generator casing, are formed. The first fluid drawn in from the first inlet passes through the heat exchanger, and then the first air blower blows out this first fluid from the first outlet that is horizontally disposed.

The second fluid drawn in from the second inlet passes through the heat exchanger, and then the second air blower blows out this second fluid from the second outlet that is vertically disposed.

If the first air blower and the second air blower form approximately orthogonal flows of a horizontal flow of the first fluid and a vertical flow of the second fluid, the same effects as those described in the exemplary embodiments of the present invention can be achieved.

The second fluid carries heat generated inside the heat generator casing to the heat exchanger. The heat of the second fluid is released to the first fluid in the heat exchanger, and then the second fluid circulates inside the heat generator casing. The first fluid absorbing the heat in the heat exchanger is blown out of the heat generator casing. Accordingly, the heat generated in the heat generator casing is released outside the heat generator casing.

The first fluid drawn in by the first air blower via the heat exchanger is blown out from the first outlet. The second fluid that exchanges the heat with the first fluid via this heat exchanger is drawn into the heat exchanger by the second air blower. The second air blower then blows out the second fluid that has exchanged the heat in the heat exchanger from the second outlet. With this structure, fluids blown out from the first outlet and the second outlet are blown out far away. As a result, occurrence of short-circuiting is prevented, improving cooling performance. In particular, since the second fluid vertically circulates, the heat-exchanging device is not necessarily installed on a door, as in the prior art. The heat-exchanging device can be placed on an upper part in the heat generator casing. Accordingly, an installation area of the heat generator casing can be reduced. In addition, predetermined cooling performance can be achieved.

### INDUSTRIAL APPLICABILITY

The heat-exchanging device and the heat generator casing of the present invention is effectively applicable to base stations of communications equipment installed in places with restricted installation area, such as a rooftop of city building, and cooling devices in other pieces of equipment installed outside.

## Claims

1. A heat-exchanging device comprising:
a first case including a first inlet for drawing in a first fluid, a first outlet for blowing out the first fluid in a direction different from a direction of drawing in the first fluid through the first inlet, a second inlet for drawing in a second fluid, and a second outlet for blowing out the second fluid in a direction different from a direction of drawing in the second fluid through the second inlet;
a first air blower housed in the first case, the first air blower forming a first passage where the first fluid flows from the first inlet to the first outlet via a first path;
a second air blower housed in the first case, the second air blower forming a second passage where the second fluid flows from the second inlet to the second outlet via a second path; and
a heat exchanger housed in the first case, the heat exchanger including the first path and the second path, and exchanging heat between the first fluid and the second fluid.

2. The heat-exchanging device of claim 1, wherein
the first case further comprising:
a third inlet at a position facing the second inlet; and
a third outlet at a position facing the second outlet;
wherein
the second air blower is a centrifugal air blower that changes a flow of the second fluid coming via the second path to a direction perpendicular to the flow.

3. The heat-exchanging device of claim 2, wherein the first case further comprising:
a first cover for covering one of the second inlet and the third inlet; and
a second cover for covering one of the second outlet and the third outlet;
wherein
the first cover and the second cover form the second passage.

4. A heat generator casing comprising:
a housing including a first wall having a first opening for drawing in a first fluid, and a second wall having a second opening for blowing out the first fluid;
a first heat-exchanging device housed in the housing, the first heat-exchanging device comprising:
a first case including a first inlet for drawing in the first fluid that is drawn in from the first opening;
a first outlet for blowing out the first fluid to the second opening, the first outlet being provided in a direction different from a direction that the first inlet draws in the first fluid;
a second inlet for drawing in a second fluid; and
a second outlet for blowing out the second fluid in a direction different from a direction that the second inlet draws in the second fluid;
a first air blower housed in the first case, the first air blower forming a first passage where the first fluid flows from the first inlet to the first outlet via a first path;
a second air blower housed in the first case, the second air blower forming a second passage where the second fluid flows from the second inlet to the second outlet via a second path; and
a first heat exchanger housed in the first case, the first heat exchanger including the first air path and the second path, and exchanging heat between the first fluid
and the second fluid;
a second case; and
a heat generator housed in the second case.

5. The heat generator casing of claim 4, wherein
the housing further comprising a third wall having a third opening for drawing in the first fluid; and
the heat generator casing further comprising a second heat-exchanging device housed in the housing, the second heat-exchanging device comprising:
a third case including a third inlet for drawing in the first fluid that is drawn in from the third opening;
a third outlet for blowing out the first fluid to the second opening, the third outlet being provided in a direction different from a direction that the third inlet draws in the first fluid;
a fourth inlet for drawing in the second fluid;
and
a fourth outlet for blowing out the second fluid in a direction different from a direction that the fourth inlet draws in the second fluid;
a third air blower housed in the third case, the third air blower forming a third passage where the first fluid flows from the third inlet to the third outlet via a third path;
a fourth air blower housed in the third case, the fourth air blower forming a fourth passage where the second fluid flows from the fourth inlet to the fourth outlet via a fourth path; and
a second heat exchanger housed in the third case, the second heat exchanger including the third path and the fourth path, and exchanging heat between the first fluid and the second fluid.

6. The heat generator casing of claim 5, wherein the first air blower, the second air blower, the third air blower, and the fourth air blower are centrifugal air blowers.

7. The heat generator casing of claim 5, wherein
the first case further comprising:
a fifth inlet at a position facing the second inlet;
a fifth outlet at a position facing the second outlet;
a first cover covering one of the second inlet and the fifth inlet; and
a second cover covering one of the second outlet and the fifth outlet;
wherein
the second air blower is a centrifugal air blower that changes a flow of the second fluid coming via the second path to a direction perpendicular to the flow; and
the first cover and the second cover form the second passage.

8. The heat generator casing of claim 5, wherein
the third case further comprising:
a sixth inlet at a position facing the fourth inlet;
a sixth outlet at a position facing the fourth outlet;
a third cover covering one of the fourth inlet and the sixth inlet; and
a fourth cover covering one of the fourth outlet and the sixth outlet;
wherein
the fourth air blower is a centrifugal air blower that changes a flow of the second fluid coming via the fourth path to a direction perpendicular to the flow; and
the third cover and the fourth cover form the fourth passage.

9. The heat generator casing of claim 4, wherein
the housing further comprising:
a fourth wall having a fourth opening on an inner side of the first wall, the fourth opening being created at a position different from a position facing the first opening and at a position facing the first inlet; and
a fifth wall having a fifth opening on an inner side of the second wall, the fifth opening being created at a position different from a position facing the second opening and at a position facing the first outlet.

10. The heat generator casing of claim 5, wherein
the housing further comprising:
a fourth wall having a fourth opening on an inner side of the first wall, the fourth opening being created at a position different from a position facing the first opening and at a position facing the first inlet;
a fifth wall having a fifth opening on an inner side of the second wall, the fifth opening being created at a position different from a position facing the second opening and at a position facing the first outlet; and
a sixth wall having a sixth opening on an inner side of the third wall, the sixth opening being created at a position different from a position facing the third opening and at a position facing the third outlet.

11. The heat generator casing of one of claims 4 and 5, further comprising a duct including a duct inlet and a duct outlet, the duct being provided in the housing;
wherein
the duct inlet is disposed at a position facing the second outlet;, and
the duct outlet is disposed at a position lower than the duct inlet.

12. The heat generator casing of claim 11, wherein the duct comprises a plurality of duct outlets including the duct outlet, the plurality of duct outlets being disposed at different heights.

13. The heat generator casing of claim 11, wherein the housing further comprising a door for opening and closing the housing, the duct being disposed on the door.

14. The heat generator casing of claim 4, wherein
the first case further comprising a first guide on a bottom face of the first case, the first guide protruding downward; and
the second case comprising:
a second guide on a top face of the second case, the second guide protruding upward;
a seventh outlet for blowing out the second fluid; and
a first guide fitting portion provided between the second guide and the seventh outlet, the first guide being fitted into the first guide fitting portion.

15. The heat generator casing of claim 14, wherein the first guide has a corner facing the second guide and the top face of the second case, the corner being slanted.

16. The heat generator casing of claim 14, wherein the second guide has a corner facing the first guide and the bottom face of the first case, the corner being slanted.

17. The heat generator casing of claim 14, wherein
the second case further comprising:
a fitting portion around the seventh outlet, the fitting portion protruding toward the first case; and
a packing provided around the fitting portion.

18. The heat generator casing of claim 17, wherein the first case further comprising an auxiliary portion at the second inlet, the auxiliary portion protruding toward inside the first case.

19. The heat generator casing of claim 14,
wherein
the first guide of the first case moves on the second guide of the second case in a predetermined direction;
the first case further includes a first attachment portion protruding along a direction perpendicular to the predetermined direction;
the second case further includes a second attachment portion on an outer surface of the second case, the second attachment portion fixing the first attachment portion; and
the housing further includes a third attachment portion on an inner surface of the housing, the third attachment portion fixing the first attachment portion.

20. The heat generator casing of claim 19, wherein the guide is fitted into the first guide fitting portion by moving the first guide on the second guide.

21. The heat generator casing of claim 19, wherein the bottom face of the first case is tilted downward from the second outlet to the second inlet.

22. The heat generator casing of claim 19, wherein the second attachment portion protrudes from an end of the outer surface of the second case in a direction opposite to the seventh outlet.
